Europäisches Patentamt

European Patent Office

Office européen des brevets

(11) Publication number: **0 164 164**
**B1**

(12) **EUROPEAN PATENT SPECIFICATION**

(45) Date of publication of patent specification: **11.10.89**

(51) Int. Cl.⁴: **G 01 N 24/04, G 01 N 24/08**

(21) Application number: **85200779.8**

(22) Date of filing: **15.05.85**

(54) Nuclear magnetic resonance apparatus with surface coil detection.

(30) Priority: **25.05.84 NL 8401671**

(43) Date of publication of application:
**11.12.85 Bulletin 85/50**

(45) Publication of the grant of the patent:
**11.10.89 Bulletin 89/41**

(84) Designated Contracting States:
**DE FR GB NL**

(56) References cited:
**WO-A-84/00214**
**GB-A-2 056 086**
**US-A-4 129 822**
**US-A-4 411 270**

**JOURNAL OF PHYSICS E: SCIENTIFIC INSTRUMENTS, vol. 13, no. 9, September 1980, pages 947-954, The Institute of Physics, London, GB; J.M.S. HUTCHISON et al.: "A whole-body NMR imaging machine"**

(73) Proprietor: **N.V. Philips' Gloeilampenfabrieken**
**Groenewoudseweg 1**
**NL-5621 BA Eindhoven (NL)**

(72) Inventor: **Boskamp, Eddy Benjamin**
**c/o INT. OCTROOIBUREAU B.V. Prof. Holstlaan 6**
**NL-5656 AA Eindhoven (NL)**
Inventor: **Kemner, Rudolf**
**c/o INT. OCTROOIBUREAU B.V. Prof. Holstlaan 6**
**NL-5656 AA Eindhoven (NL)**

(74) Representative: **Scheele, Edial François et al**
**INTERNATIONAAL OCTROOIBUREAU B.V. Prof. Holstlaan 6**
**NL-5656 AA Eindhoven (NL)**

(56) References cited:
**ELECTRO/78 CONFERENCE RECORD, 23rd-25th May 1978, Boston, US, pages 30/2-1 - 30/2-15; CHING-MING LAI et al.: "Nuclear magnetic resonance zeugmatography for medical imaging"**

Courier Press, Leamington Spa, England.

## Description

The invention relates to a nuclear magnetic resonance apparatus including means for generating a homogeneous main magnetic field, means for generating gradient fields, and a radio-frequency coil system for generating and detecting magnetic resonance signals in an object under examination, said radio-frequency coil system being provided with an electronic decoupling circuit for decoupling a measurement surface coil during energisation of a radio-frequency excitation coil.

A nuclear magnetic resonance apparatus of this type is known from Computer Tomography, 1, 1981, pp. 2—10, and Chapter 8, page 164 of the book "Nuclear magnetic resonance and its applications to living systems" by D. G. Gadian, Clarendon Press Oxford, 1982 deals with the advantage of using a so-called surface coil for blood stream measurements. Advantages mentioned therein are the relatively favourable value which is achievable for the signal-to-noise ratio in the detection process, the possibility of making an accurate measurement in a relatively small region near the coil and the possibility of adapting the shape and size of the coil to the shape and size of an object to be measured. For generating the radio-frequency electromagnetic excitation field a larger coil is used, often called a body coil, because otherwise the spatial homogeneity of the field will be insufficient. If it is desired in such an apparatus for one reason or another to position the excitation coil relative to a surface coil acting as a measurement coil in any manner other than mutually perpendicularly, serious disturbing effects will occur. The surface coil will then be inductively excited by the excitation field to such an extent that the detection circuit will become overloaded, which may for instance lead to the destruction of a pre-amplifier. Conversely, during excitation the current induced in the surface coil will interfere with the radio-frequency excitation field so that, for example, incorrent 90° and 180° excitation pulses will be produced. These effects will result in a severe limitation to the possible applications of surface coils or, on the other hand, many of the advantages of the surface coil will be lost due to these undesired effects.

By making provisions for the surface coil the invention aims at providing an apparatus for nuclear magnetic resonance measurements in which the surface coil can be used in all positions and orientations.

To achieve this an NMR apparatus of the kind mentioned in the preamble is in accordance with the invention, characterized in that the electronic decoupling circuit includes an electronically controllable variable capacitive element.

Since the surface coil in a nuclear magnetic resonance apparatus according to the invention is decoupled during the time the excitation coil is energised, no disturbing induction current will occur in it, irrespective of the mutual orientation of the excitation coil and the measurement coil.

Preferably the surface coil, at least during excitation by the radio-frequency excitation coil, is tuned to a frequency which is significantly higher than the operating frequency of the system. A higher frequency is favourable, since otherwise the measurement coil would remain strongly current-conducting.

The decoupling effect is implemented by using a variable capacitor as the C value for the tuned circuit of the surface coil. Upon decoupling, the C value is lowered, as a result of which the natural frequency of the tuned circuit will be increased. If a single variable capacitor, for example in the form of an electrically controllable varicap, cannot withstand the voltages that occur, it is favourable to connect several of such capacitors in series. To maintain a correct total capacitance value it is then desirable to connect several series-connected groups of capacitors in a parallel arrangement.

In a preferred embodiment, which is provided with a balun connection or some other provision for symmetrical detection, the decoupling circuit is located between that connection and the ends of the actual surface coil. It is often favourable to include a high-ohmic resistor between a power source for supplying the decoupling circuit and the actual decoupling circuit. This ensures that the Q value of the tuned circuit for the working frequency is not adversely affected.

In another preferred embodiment the radio-frequency excitation coil is short-circuited by a relatively small resistance during detection with the measurement coil, preferably by means of a diode bridge. The shorting circuit preferably contains for this purpose two series arrangements of a diode and a resistor. To avoid mutual interference here too, the shorting circuit and its power source are interconnected, for example by means of a bridge circuit.

It is remarked, that decoupling systems for nuclear magnetic resonance apparatus per se are known from the publications Journal of Physics E. Sci. Instr., Vol. 13, No. 9, Sept. 1980, pages 947—955; Electro-78 Conference Record, 23—25 May, 1978, Boston US, pages 30/2, 1—15; and Chemical Physics Letters, Vol. 99, No. 4, 12 August, 1983, pages 310—315. Decoupling systems based on a crossed diode circuit do not always satisfy the required decoupling and are especially less appropriate for relative high frequency measurings.

Yet another preferred embodiment contains at least two identical or nearly identical surface coils which are each provided with a decoupling circuit. It may be favourable here to interconnect the decoupling circuits in such a way as to produce an automatic mutual relation for activation of each of the decoupling circuits. The application of several surface coils in a single apparatus is for example favourable for eye, ear and mammary examinations. Advantageous use can also be made of two surface coils for examinations on objects, for example patients, that fit too liberally in the excitation coils, which owing to the requirement that it must also be possible to examine relatively corpulant patients, will be the case for most patients. The surface coils can then both be applied directly against the object under examination, and since here too a larger excitation coil is used for achieving a spatially homogeneous excitation field for the excitation of nuclear magnetic resonance, each of the surface coils is provided with a decoupling circuit. These circuits can be interconnected.

In the following some preferred embodiments of the invention will be described in more detail with reference to the drawings, in which:

Figure 1 shows schematically a nuclear magnetic resonance apparatus provided with two surface coils,

Figure 2 shows schematically a coil system with a body coil and two surface coils,

Figure 3 shows an example of a decoupling circuit for a surface coil,

Figure 4 shows a more detailed switching circuit with a decoupling circuit of this type,

Figure 5 shows an example of a shorting circuit for a body coil in a coil system in accordance with the invention.

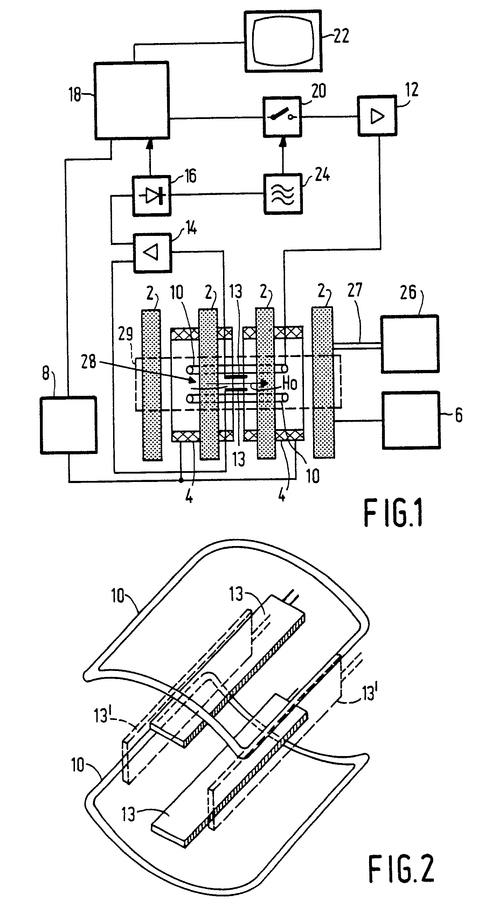

A nuclear magnetic resonance apparatus as represented in figure 1 contains a coil system 2 for generating a stationary homogeneous magnetic field Ho, a coil system 4 for generating radiant magnetic fields, possibly power sources 6 and 8 for respectively the coil system 2 and the coil system 4. A coil 10 serves for generating a radio-frequency alternating magnetic excitation field and is connected for this purpose to a radio-frequency source 12. For detecting the nuclear magnetic resonance signals generated by the radio-frequency excitation field in an object under examination use is made in this embodiment of two surface coils 13. For read-out both the coils 13 are connected to a signal amplifier 14. The signal amplifier 14 is connected to a phase-sensitive rectifier 16 which is connected to a central control system 18. The central control system 18 further controls a modulator 20 for the radio-frequency source 12, the power source 8 for the gradient coils and a monitor 22 for image display. A high-frequency oscillator 24 drives both the modulator 20 and the phase-sensitive rectifier 16 which processes the measurement signals. Cooling, where required, of electromagnet coils for the main field is performed by a cooling system 26 with cooling pipes 27. A cooling system of this type can be implemented as water cooling for resistance coils or as liquid helium cooling for superconducting magnet coils. The excitation coils 10 within the magnet systems 2 and 4 enclose a measurement space 28 which, in an apparatus for medical diagnostic measurements, is roomy enough to accommodate patients within amply specified size limits. Thus there must be generated in the measurement space 28 a homogeneous magnetic field Ho, gradient fields needed for selecting the position of a cross-section to be displayed and a spatially homogeneous radio-frequency alternating field. The surface coils 13 are to be adjustably placed within the space 28. For certain examinations such as on vertebrae and general body examinations it is desirable to incorporate one of the coils in a patient support table, which support table should be axially displaceable and radially adjustable in relation to the space 28, and the second coil can be separately introduced in such a way that it can be adapted to the body or to the part of the body under examination. Both the coils 13, or for many measurements, a single coil 13, would then usually, during the course of the examination, in fact be coupled to the patient and preferably be moved with the patient when the latter is repositioned.

Figure 2 shows in perspective the excitation coils 10 and the surface coils 13, in position relative to one another. The mutual orientation sketched therein will for convenience be defined as a parallel orientation, because in that case, due to the relative arrangement of the windings of the excitation coils and the surface coils, the planes of the coils are arranged substantially parallel to one another. A disposition of surface coils 13', indicated by dashed lines, will be defined as perpendicular orientation. It is often only in this perpendicular orientation that no interfering induction current will be generated in the surface coils by the excitation coils. Due to part of the surfaces of the excitation coils having the form of a cylindrical sleeve and due to a fanning out of the excitation field, this will only be applicable to a first approximation. For many kinds of examination the perpendicular orientation will not be optimal, and owing to the mutual inductive coupling between the excitation and measurement coils, the scope of an examination with such a setup will be significantly limited.

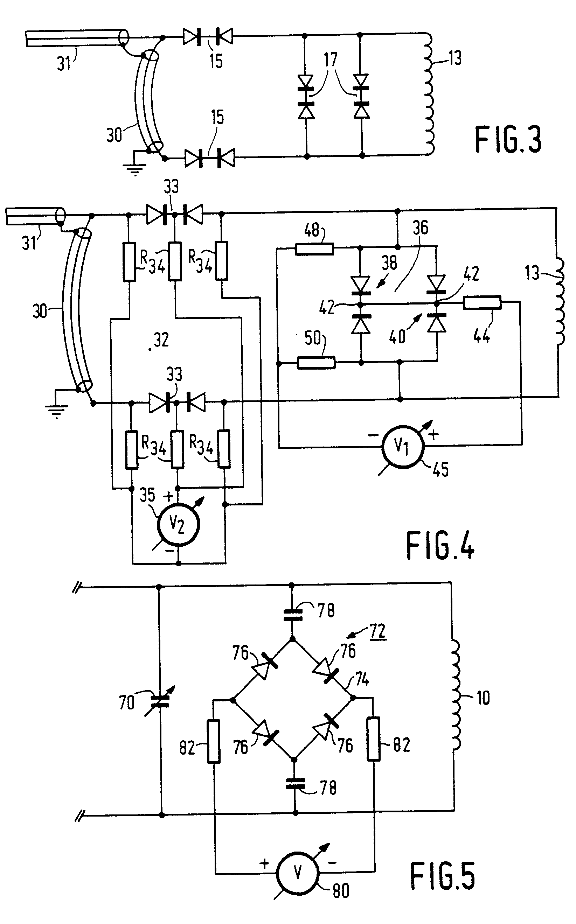

This limitation is removed with a decoupling circuit for the surface coil. Figure 3 gives an elementary circuit diagram for such a decoupling circuit. The surface coil 13 to be decoupled formed here with a balun connection 30 for symmetrical drive and two variable capacitive elements 15, preferably in the form of varicaps, an LC tuning circuit. With the aid of variable capacitive elements 17, again preferably in the form of varicaps, this LC circuit can now be decoupled, for which purpose the capacitance of preferably all varicaps can be set to a significantly lower value. A supply lead 31 connects the whole arrangement to a read-out device, not detailed here, such as the device 14 in figure 1.

A more detailed switching circuit as shown in figure 4 contains the coil 13, a balun connection 30, a connector 31 and a tuning circuit 32, as described on pages 170—171 of the said book by Gadian, but here provided with two varicaps 33 which, via decoupling resistors 34, are connected to a power source 35. A decoupling circuit 36 has here two variable capacitors 38 and 40 whose intermediate contacts 42 are connected via a high-frequency decoupling resistor 44 with, in this case, the positive pole of a power source 45. The other respective connections to the varicaps 38 and 40, which do not form the intermediate contacts 42, are each jointly connected via high-frequency decoupling resistors 48 and 50 to the negative pole of a power source 45. The two power sources 35 and 45 can be implemented as a single power source. The matching circuit, which is here provided with varicaps 33, could alternatively be implemented with mechanically variable capacitors or other adjustable capacitors, but the embodiment sketched here has certain technological advantages as regards reliability and switching speed. The resistance value of the decoupling resistors is for example about 500 kΩ. A pre-amplifier can, as before, be connected to the lead 31.

The decoupling circuit which, in the sketched example, contains two varicaps can alternatively be provided with one varicap or with a series-parallel assembly of several varicaps, depending on the maximum voltage which is expected to occur across the varicap arrangement. The supply voltage for the decoupling circuit and here also for the matching circuit, can be adjusted by adjusting the supply source 45.

During detection of the nuclear magnetic resonance signals generated in the object under examination the excitation coil and the measurement coil or measurement coils are all at the same frequency, called the Larmor frequency. This often gives rise to coupled resonant circuits, resulting in a lowering of the Q value and tuning problems with the measurement coils, in this case the surface coils. Decoupling the excitation coil as described in the foregoing for the measurement coils is not practicable since in the present case, owing to the relatively high voltages and high powers, use cannot readily be made of the variable capacitors described. A solution for this is a shorting circuit as indicated in figure 5. The excitation coil 10, which forms an LC circuit with a variable tuning capacitor 7, can here be controllably short-circuited by means of a shorting circuit 72 constituted by a relatively small resistance and formed by a bridge arrangement 74 of four diodes 76 and two, in principle fixed-value, relatively large, decoupling capacitors 78. The bridge network is fed from a variable power source 80 which is connected to the bridge circuit via two relatively high-ohmic value decoupling resistors 72. By activating the shorting circuit 72 at least during signal detection, the LC circuit will be tuned to a different natural frequency since the lower resistance value R of the coil 10 will then be replaced by the impedance value $R+i\omega L$ of the coil 10. As a result of this the undesirable effect referred to will not occur. A further limitation in the use of the surface coils, particularly when measuring larger objects, is the fact that the effective field region of a surface coil is relatively restricted and does not extend in depth much beyond a distance corresponding to the coil surface dimensions. In order to avoid interfering effects from regions which generate relatively small signals it is, however, desirable to pick up signals up to a distance equal to twice the size of the coil which, particularly because of the consequent higher noise contribution, imposes a limitation on the accuracy of measurement. When two surface coils are used as measurement coils with an object to be examined placed between these coils, this drawback is overcome by, during excitation, decoupling one of the measurement coils and not the other, or, if that is disadvantageous for the apparatus, by only partly decoupling. The not completely decoupled measurement coil then compensates the excitation field of the excitation coil over a distance which is again dependent on the surface area of the coil and on the degree of decoupling. The greatest amount of compensation will then be obtained when the second measurement coil is not decoupled at all. During detection with the first measurement coil, which was thus completely decoupled during excitation, there is now no need to carry out the measurement over an extra large distance, to the benefit both of the signal-to-noise ratio and of the resolution of the measurement signals. During this detection the second measurement coil is preferably completely decoupled and the excitation coil short-circuited in the manner indicated. It will be evident that within this procedure the functions of the two measurement coils can be changed over. The method results without loss of spatial resolution, in a shortened measurement and reconstruction time and, as already remarked, in a better signal-to-noise ratio or, with the same measurement time, in a higher spatial resolution.

In apparatus in which, for example, both an excitation coil for body measurements and an excitation coil for head measurements are used, it may be favourable to add shorting circuits to these coils as well. These shorting circuits can, as in the previous example, be mutually coupled. In this way any disturbance of the excitation signals by the coils can be avoided or at least sufficiently reduced.

In a practical example of a nuclear magnetic resonance apparatus with a superconducting magnet coil it is often the case that the noise component of the measurement signal is determined by the object under measurement. When measuring a transverse slice (sectional region) of the object of the whole of the object in the measurement space is excited, and while measuring the slice (sectional region), noise from whole of the object however, will contribute to the noise in the measurement signal. If, however, the measurement is made not with the excitation coil but with two surface coils which in accordance with the invention are decoupled during excitation, then only the noise from that region of the object which is determined by the width of that coil will contribute to the noise in the measurement signal. With a body coil having the usual opening of 50 cm and a length of about 60 cm and surface coils of for example $10\times40$ cm$^2$, as commonly used for examinations of the spinal cord, the volume of that region of the object which contributes to the noise while measuring a vertical sectional region can be reduced in the proportion of the coil dimension in the direction at right angles to the section, i.e. in the ratio of 60 to 10. A similar reduction can be obtained in the measurement of a sagittal section. Here the surface coils are positioned with a 90° rotation. Because of this the signal-to-noise ratio for a coronal section cannot be improved, and for these measurements the excitation coil can then also be used as measurement coil. The surface coils are then decoupled or possibly removed from the apparatus.

For measurements in a nuclear magnetic resonance apparatus provided with conventional resistive coil (e.g. copper) windings for generating the main field, the equipment itself is usually the determining factor with regard to noise. With for example circular surface coils having a diameter of 30 cm a gain in the signal-to-noise ratio of a factor of two can then be achieved compared with a measurement using the excitation coil.

## Claims

1. Nuclear magnetic resonance apparatus including means (2) for generating a homogeneous main magnetic field ($H_0$), means (4) for generating gradient fields, and a radio-frequency coil system for generating and detecting magnetic resonance signals in an object under examination, said radio-frequency coil system being provided with an electronic decoupling circuit (36) for decoupling a measurement surface coil (13) during energisation of a radio-frequency excitation coil (10), characterized in that the electronic decoupling circuit (36) includes an electronically controllable variable capacitive element (17, 38, 40).

2. Nuclear magnetic resonance apparatus as claimed in Claim 1, characterized in that the electronic decoupling circuit contains several variable capacitive elements (38, 40) arranged in series-parallel circuit arrangement.

3. Nuclear magnetic resonance apparatus as claimed in claim 1 or 2, characterized in that the electronic decoupling circuit is incorporated between a symmetrical i.e. balanced connection to be made across the coil and the ends of the coil (13).

4. Nuclear magnetic resonance apparatus as claimed in any one of the foregoing claims, characterized in that a power source (45) for the electronic decoupling circuit (36) is connected with the decoupling circuit via high-ohmic value resistors (44, 49, 50) which do not substantially affect the Q-factor of the coil.

5. Nuclear magnetic resonance apparatus as claimed in any one of the foregoing claims, characterized in that the radio-frequency excitation coil is shorted during detection by the detection coil via a short circuit (72).

6. Nuclear magnetic resonance apparatus as claimed in Claim 5, characterized in that the shorting circuit (72) for the excitation coil (10) contains a bridge circuit (74) or diodes (76) connected via resistors (82) with a power source (80).

7. Nuclear magnetic resonance apparatus as claimed in any one of the preceding claims, characterized in that the detection device contains two almost identical surface coils which are each provided with mutually interconnected decoupling circuits.

8. Nuclear magnetic resonance apparatus as claimed in Claim 7, characterized in that a first detection coil is incorporate in a carrier table for an object under examination and a second coil is physically mountable at an opposite side of the object.

## Patentansprüche

1. Kernsprinresonanzapparat mit Mitteln (2) zum Erzeugen eines homogen Hauptmagnetfelds ($H_0$), mit Mitteln (4) zum Erzeugen von Gradientenfeldern und mit einem Hf-Spulensystem zum Erzeugen und Detektieren von Kernspinresonanzsignalen in einem in Untersuchung befindlichen Objekt, wobei das Hf-Spulensystem mit einem elektronischen Entkoppler (36) zum Entkoppeln einer Meßflächenspule (13) beim Erregen einer Hf-Anregungsspule (10) versehen ist, dadurch gekennzeichnet, daß der elektronische Entkoppler (36) ein elektronisch steuerbares, kapazitives Element (17, 38, 40) enthält.

2. Kernspinresonanzapparat nach Anspruch 1, dadurch gekennzeichnet, daß der elektronische Entkoppler mehrere regelbare kapazitive Elemente (38, 40) in serien/paralleler Schaltungsanordnung enthält.

3. Kernspinresonanzapparat nach Anspruch 1 oder 2, dadurch gekennzeichnet, daß der elektronische Entkoppler in eine über die Spule und die Enden der Spule (13) herzustellende, symmetrische, d.h. abgeglichene, Verbindung aufgenommen ist.

4. Kernspinresonanzapparat nach einem oder mehreren der vorangehenden Ansprüche, dadurch gekennzeichnet, daß eine Energiequelle (45) für den elektronischen Entkoppler (36) mit dem Entkoppler über hochohmige Widerstände (44, 49, 50) verbunden ist, die den Q-Faktor der Spule nicht wesentlich beeinflussen.

5. Kernspinresonanzapparat nach einem oder mehreren der vorangehenden Ansprüche, dadurch gekennzeichnet, daß die Hf-Anregungsspule bei der Detektion durch die Detektionsspule über einen Kurzschluß (72) kurzgeschlossen wird.

6. Kernspinresonanzapparat nach Anspruch 5, dadurch gekennzeichnet, daß der Kurzschluß (72) für die Anregungsspule (10) eine über Widerstände (82) mit einer Energiequelle (80) verbundene Brückenschaltung (74) oder auch solche Dioden (76) enthält.

7. Kernspinresonanzapparat nach einem oder mehreren der vorangehenden Ansprüche, dadurch gekennzeichnet, daß der Detektor zwei nahezu gleiche Oberflächenspulen enthält, die mit je untereinander verbundenen Entkopplern versehen sind.

8. Kernspinresonanzapparat nach Anspruch 7, dadurch gekennzeichnet, daß eine erste Detektorspule in einen Untersuchungstisch für ein in Untersuchung befindliches Objekt aufgenommen und eine zweite Spule fysikalisch an einer gegenüber liegenden Seite des Objekts montierbar ist.

**Revendications**

1. Appareil de résonance magnétique nucléaire comprenant un dispositif (2) pour engendrer un champ magnétique principal magnétique homogène (Ho), un dispositif (4) pour engendrer des champs de gradients, et un système de bobines radiofréquence pour engendrer et détecter des signaux de résonance magnétique dans un objet examiné, le système de bobines radiofréquence étant pourvu d'un circuit de découplage électronique (36) pour découpler une bobine de surface de mesure (13) pendant l'excitation d'une bobine d'excitation radiofréquence (10), caractérisé en ce que le circuit de découplage électronique (36) comprend un élément capacitif variable pouvant être commandé électroniquement (17, 38, 40).

2. Appareil de résonance magnétique nucléaire suivant la revendication 1, caractérisé en ce que le circuit de découplage électronique contient plusieurs éléments capacitifs variables (39, 40) disposés dans un montage de circuits série-parallèle.

3. Appareil de résonance magnétique nucléaire suivant la revendication 1 ou 2, caractérisé en ce que le circuit de découplage électronique est inclus entre une connexion symétrique, c'est-à-dire équilibrée, à réaliser sur la bobine et les extrémités de la bobine (13).

4. Appareil de résonance magnétique nucléaire suivant l'une quelconque des revendications précédentes, caractérisé en ce qu'une source de courant (45) pour le circuit de découplage électronique (36) est connectée au circuit de découplage par l'intermédiaire de résistances à haute valeur ohmique (44, 49, 50) qui n'affectent sensiblement par le facteur Q de la bobine.

5. Appareil de résonance magnétique nucléaire suivant l'une quelconque des revendications précédentes, caractérisé en ce que la bobine d'excitation radiofréquence est court-circuitée pendant la détection par la bobine de détection par l'intermédiaire d'un circuit court-circuiteur (72).

6. Appareil de résonance magnétique nucléaire suivant la revendication 5, caractérisé en ce que le circuit court-circuiteur (72) pour la bobine d'excitation (10) contient un circuit en pont (74) de diodes (76) connecté par l'intermédiaire de résistances (82) à une source de courant (80).

7. Appareil de résonance magnétique nucléaire suivant l'une quelconque des revendications précédentes, caractérisé en ce que le dispositif de détection contient deux bobines de surface presque identiques qui sont pourvues chacune de circuits de découplage mutuellement interconnectés.

8. Appareil de résonance magnétique nucléaire suivant la revendication 7, caractérisé en ce qu'une première bobine de détection est incorporée dans une table de support pour un objet à examiner et une seconde bobine peut être montée physiquement d'un côté opposé de l'objet.

FIG.1

FIG.2

1

EP 0 164 164 B1

FIG.3

FIG.4

FIG.5

2